# EUROPEAN PATENT APPLICATION

(11) **EP 2 144 297 A1**
(43) Date of publication of application: **13.01.2010**
(21) Application number: 08159846.8
(22) Date of filing: 07.07.2008
(51) Int. Cl.: H01L 31/0384, H01L 31/052, H01L 31/0216

(54) **Solar device and method of generating electric power**

(71) Applicant: Technische Universiteit Delft, 2628 CN Delft (NL)
(72) Inventor: Vuong, Luat Thanh, Vienna, VA 22182 (US)
(74) Representative: Van Breda, Jacobus

(57) **Abstract**

The present invention relates to a solar device comprising a conglomerate of asymmetric electrically-conducting nanoparticles in combination with a filter for circularly polarizing incident light to excite the nanoparticles, wherein the asymmetric nanoparticles are aligned so as to cause that said nanoparticles generally occupy a same predefined orientation within the conglomerate.

## Description

The invention relates to a solar device and a method of generating electric power.

The solar device of the invention may be a solar battery, a sensor or a detector, all employing the same inventive principle as will be illustrated hereinafter. For purposes of explanation the invention will hereinafter primarily be elucidated with reference to the construction of a solar battery, without however implying that the rights derived from this application will be restricted thereto.

Currently most solar cells require a semiconductor material to produce a voltage via the photoelectric effect. Incident sunlight produces excitons or electron-hole pairs, which either diffuse or drift before being collected by electrodes. The solar cells are expensive to manufacture because the semiconducting materials must be free of the defects that cause deleterious exciton recombination or lead to further material degradation. Moreover, current designs typically involve time-consuming and expensive lithographic manufacturing processes for making, for example, transparent electrodes, multiple-junction semiconducting layers, or highly-structured materials that improve the 'drift' and 'diffusion' collection of excitons.

The object of the invention is to enter new ground and propose a different type of solar device, particularly a solar battery, avoiding the pitfalls and problems of the prior art. The invention also has as an objective to provide a method of generating electric power with such a solar battery.

The solar device and the method of generating electric power with a solar battery according to the invention are characterized by one or more of the appended claims.

In a first aspect of the invention the solar device is comprised of a conglomerate of asymmetric electrically-conducting nanoparticles in combination with a filter for circularly polarizing incident light to excite the nanoparticles.

When the solar device is a solar battery, it is thus possible to generate an electrical potential energy or voltage by the steps of
- circularly polarizing light from a light source into an incident light beam of circularly-polarized light
- projecting the incident light beam onto a conglomerate of asymmetric electrically-conducting nanoparticles to induce on said nanoparticles electrical dipoles
- collecting an aggregate power derived from said electrical dipoles from preselected connecting locations on said conglomerate of nanoparticles.

The invention is based on the insight that when circularly-polarized light is incident on a subwavelength-sized metal asymmetric object, the free electrons along the surface of the metal experience a force in the azimuthal direction. Thus, a net charge will accumulate at different locations along the structure of the nanoparticles having such an asymmetric shape and being subjected to said circularly-polarized light.

To further the efficiency of the solar device of the invention it is desirable that the asymmetric nanoparticles are aligned so as to cause that said nanoparticles generally occupy a same predefined orientation within the conglomerate.

Effectively, the construction of the solar device may take many forms provided that the nanoparticles are embodied in a substance selected from a group comprising gases, liquids and solid materials. Such selected substance must have a finite-valued electron mobility.

For the manufacturing of the conglomerate of asymmetric electrically conducting nanoparticles, reference is made to the article 'Fabrication of crescent-shaped optical antennas' by J.S. Shumaker-Perry, H. Rochholz and M. Kreiter, published in Advanced Materials 17, 2005, pp. 2131-2134, which citation is deemed to be fully incorporated and inserted herein.

With regard to aligning the nanoparticles so as to cause that they generally occupy a same predefined orientation, reference is made to the article 'Orientation of core-shell nanoparticles in an electric field' by Jonghyun Park and Wei Lu, published in Applied Physics Letters 91, (2007), pp. 053113-053115, which document is deemed fully incorporated and inserted herein.

The invention will hereinafter be further explained with reference to a very schematic example of a solar battery according to the invention and with reference to the drawing.

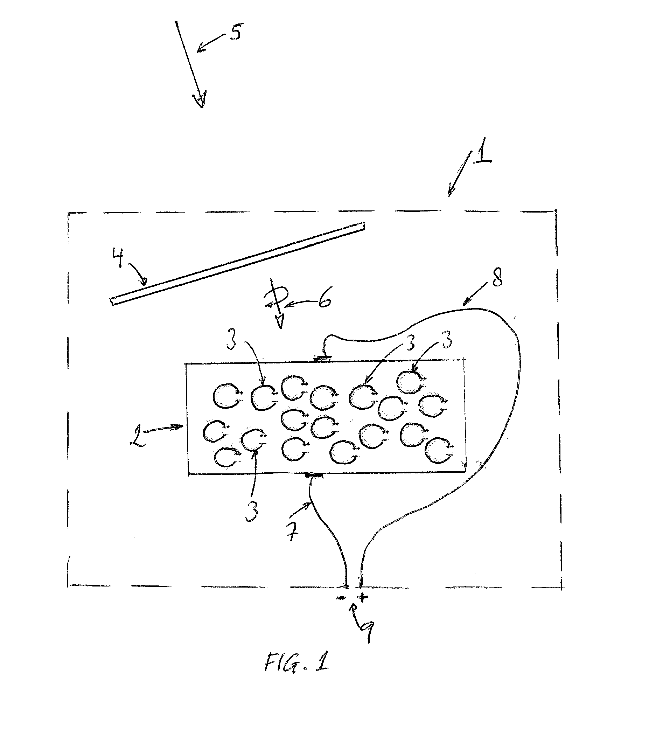

In the drawing a single Fig. 1 shows schematically the solar battery 1 of the invention. It is however again emphasized that the invention generally relates to a solar device as specified in the appended claims, and that the following explanation shall not serve to limit said claims.

The solar battery 1 shown in Fig. 1 comprises a conglomerate 2 of electrically conducting nanoparticles 3 within a material of finite electron mobility, in combination with a filter 4 for circularly polarizing incident light to excite the nanoparticles 3.

Fig. 1 schematically shows the effect of the filter 4 by indicating with arrow 5 light that originates from a light source which passes through the filter 4, which converts the light 5 into an incident light beam 6 of circularly-polarized light that projects onto the conglomerate 2 of asymmetric electrically conducting nanoparticles 3 to induce on said nanoparticles 3 electrical dipoles.

At opposite sides of the conglomerate 2 of asymmetric nanoparticles 3 power connections 7 and 8 are connected to collect the aggregate power derived from the electrical dipoles of the nanoparticles 3 which connect to the outlet 9 of the battery 1.

Fig. 1 further shows that the asymmetric nanoparticles 3, that in this particular case are shaped in the form of the letter C, are all aligned having their open side of the C directed to the right. The alignment of the nanoparticles 3 such that the particles occupy a same predefined orientation in the conglomerate 2 can be achieved during manufacturing of the battery 1 by the application of a suitable electrical field such as disclosed in the article orientation of core-shell nanoparticles in an electric field' mentioned hereinabove.

It is further desirable that the laterally-positioned neighbouring nanoparticles 3 are free from direct physical contact among each other so as to avoid short-circuiting of the dipoles.

The conglomerate 2 of nanoparticles 3 can be made by having the nanoparticles 3 embedded in a suitable material to resemble a conglomerate matrix or colloid. Basically, the nanoparticles 3 may be for this purpose embedded in any suitable substance with finite electron mobility selected from the group comprising gases, liquids and solid materials.

## Claims

1. Solar device (1) comprising a conglomerate (2) of asymmetric electrically-conducting nanoparticles (3) in combination with a filter for circularly polarizing incident light to excite the nanoparticles.

2. Solar device according to claim 1, wherein the asymmetric nanoparticles (3) are aligned so as to cause that said nanoparticles (3) generally occupy a same predefined orientation withinin the conglomerate (2).

3. Solar device according to claim 1 or 2, wherein laterally-positioned neighbouring nanoparticles (3) are free from direct physical contact among each other.

4. Solar device according to any one of claims 1-3, wherein the nanoparticles (3) are embodied in a substance with finite-valued electron mobility selected from a group comprising gases, liquids and solid materials.

5. Solar device according to any one of claims 1-4, selected from the group comprising a solar battery, a sensor, a detector.

6. Method of generating electrical energy **characterized by** circularly polarizing light (5) from a light source into an incident light beam of circularly-polarized light (6)
- projecting the incident light beam (6) onto a conglomerate (2) of asymmetric electrically-conducting nanoparticles (3) to induce on said nanoparticles (3) electrical dipoles
- collecting an aggregate power derived from said electrical dipoles from preselected connecting locations on said conglomerate of nanoparticles.
